# EUROPÄISCHE PATENTSCHRIFT

(11) **EP 4 300 351 B1**
(45) Veröffentlichungstag und Bekanntmachung des Hinweises auf die Patenterteilung: **06.08.2025**
(21) Anmeldenummer: 23172697.7
(22) Anmeldetag: 11.05.2023
(51) Int. Cl.: G06K 7/00, H03K 17/96, G06K 7/10

(54) **LESEVORRICHTUNG ZUM BERÜHRUNGSLOSEN AUSLESEN VON INFORMATIONEN AUF OBJEKTEN UND VERFAHREN ZUR ABSICHERUNG EINER SOLCHEN LESEVORRICHTUNG**
READING DEVICE FOR THE CONTACTLESS READING OF INFORMATION ON OBJECTS AND METHOD FOR SECURING SUCH A READING DEVICE
DISPOSITIF DE LECTURE POUR LIRE SANS CONTACT DES INFORMATIONS SUR DES OBJETS ET PROCÉDÉ DE SÉCURISATION D'UN TEL DISPOSITIF DE LECTURE

(30) Priorität: 28.06.2022 DE 102022116032
(43) Veröffentlichungstag der Anmeldung: 03.01.2024
(73) Patentinhaber: SICK AG, 79183 Waldkirch (DE)
(72) Erfinder: SCHÜTZ, Frank, 79365 Rheinhausen (DE)
(74) Vertreter: Manitz Finsterwald Patent- und Rechtsanwaltspartnerschaft mbB

(56) Entgegenhaltungen:
- DE-U1- 202015 009 222
- JP-A- 2019 219 703
- US-A1- 2013 181 050
- US-A1- 2014 374 474

## Beschreibung

Die Erfindung betrifft eine Lesevorrichtung zum berührungslosen Auslesen von Informationen (z.B. Barcodes, RFID-Tags) auf Objekten und ein Verfahren zur Absicherung einer solchen Lesevorrichtung.

Lesevorrichtungen, die auch als Identifikationsgeräte bezeichnet werden können, werden insbesondere dazu eingesetzt, um Informationen, insbesondere in Form von 1D-Codes (Barcodes), 2D-Codes (QR-Codes) und/oder RFID-Tags auf Objekten zu lesen. Ein Objekt, kann ein konkretes Produkt als auch dessen Verpackung sein. Die auslesbaren Informationen können dabei direkt auf das Objekt aufgebracht sein (1D, 2D-Codes können auflackiert oder aufgedruckt sein) oder indirekt auf das Objekt aufgebracht sein (Etiketten mit 1D-Codes, 2D-Codes oder RFID-Tags können aufgeklebt sein).

Diese Objekte werden, beispielsweise auf einem Förderband, an der Lesevorrichtung vorbeigeführt. Die Lesevorrichtung ist an der Lesestelle so montiert und eingerichtet, dass eine optimale Lesung mit der bestmöglichen Qualität erreicht wird. Wenn es im weiteren Betriebsablauf zu Ausfällen der Lesung kommt oder zu einer verminderten Qualität (schlechtere Leserate), dann sind die Ausfallzeiten oftmals Zeit- und somit auch kostenintensiv. Die Fehleranalyse ist häufig nicht eindeutig, was wiederum Einfluss auf die Ausfalldauer hat. Steigt die Ausfalldauer, so steigen in der Regel auch die Ausfallkosten.

Die DE 20 2015 009222 U1 zeigt ein tragbares mobiles Endgerät, welches ein gekrümmtes Anzeigemodul umfasst. Das mobile Endgerät weißt weiterhin einen Berührungssensor auf, durch den festgestellt werden kann, ob eine Person das gekrümmte Anzeigemodul berührt.

Die JP 2019 219703 A zeigt einen tragbaren Scanner, der eine Lesevorrichtung aufweist. Der tragbare Scanner umfasst berührungsempfindliche Sensoren, die Berührungen einer Person zur Bedienung des tragbaren Scanners erkennen.

Die US 2013/181050 A1 zeigt einen tragbaren Scanner, der einen Bildschirm umfasst. Bei diesem Bildschirm handelt es sich um einen berührungsempfindlichen Bildschirm, der Berührungen auf seiner Oberfläche erkennt.

Die US 2014/374474 A1 zeigt ein tragbares elektronisches Gerät, beispielsweise in Form eines Tablets, welches einen Bildschirm umfasst. Bei diesem Bildschirm handelt es sich um einen berührungsempfindlichen Bildschirm, der Berührungen auf seiner Oberfläche erkennt.

Es ist daher die Aufgabe der hier vorliegenden Erfindung eine Lesevorrichtung zu schaffen, die eine geringere Ausfallzeit und insbesondere eine einfachere Fehleranalyse aufweist.

Die Aufgabe wird durch die Lesevorrichtung des unabhängigen Anspruchs 1 gelöst. Anspruch 13 beschreibt ein Verfahren zur Absicherung einer Lesevorrichtung. Die Ansprüche 2 bis 12 geben erfindungsgemäße Weiterbildungen der Lesevorrichtung wieder.

Die erfindungsgemäße Lesevorrichtung dient zum berührungslosen Auslesen von Informationen (z.B. 1D-Code (Barcodes), 2D-Code (QR-Codes), RFID-Tags) auf Objekten, die an der Lesevorrichtung vorbei führbar sind. Die Lesevorrichtung umfasst eine Datenverarbeitungseinheit, eine Scannereinheit, eine Kommunikationseinheit, eine Berührungserkennungseinheit und ein Gehäuse. Die Berührungserkennungseinheit ist dazu ausgebildet, um Berührungen des Gehäuses der Lesevorrichtung zu erkennen.

Es ist besonders vorteilhaft, dass über die Berührungserkennungseinheit Berührungen des Gehäuses erkannt werden können. Bevorzugt ist die Berührungserkennungseinheit dazu ausgebildet, um jede Art von Berührung (egal ob sanft oder kräftig, kurz oder lang) am gesamten Gehäuse zu erfassen. So führen Berührungen der Lesevorrichtung häufig dazu, dass diese in ihrer Ausrichtung verändert und daher die Fehlerrate beim Lesen der Information auf den Objekten zunimmt. Weiterhin kann es auch zur Verschmutzung eines optischen Sensors der Scannereinheit kommen, wodurch die Fehlerrate beim Lesen der Information ebenfalls zunimmt.

Die Kommunikationseinheit dient insbesondere dazu, um Daten, wie beispielsweise die ausgelesene Information, an eine übergeordnete Datenverarbeitungsvorrichtung zu übertragen. Die Anbindung an die übergeordnete Datenverarbeitungsvorrichtung erfolgt insbesondere kabelgebunden. Sie könnte auch kabellos erfolgen. Die Kommunikationseinheit stellt insbesondere eine TCP/IP-Verbindung, Ethernet-Verbindung, Profibus, Profinet und/oder CAN-Bus zur Verfügung.

Die Berührungserkennungseinheit kann Teil der Datenverarbeitungseinheit sein. Sie kann auch separat zur Datenverarbeitungseinheit angeordnet sein und dazu ausgebildet sein, um mit der Datenverarbeitungseinheit zu kommunizieren.

Gemäß einer vorteilhaften Ausführungsform umfasst die Scannereinheit ein optisches Scannermodul. Dadurch ist die Scannereinheit dazu ausgebildet, um optische Codes, insbesondere 1D-Codes und/oder 2D-Codes zu lesen. Das Scannermodul kann beispielsweise eine Lasereinheit und/oder eine Kamera umfassen.

Ergänzend oder alternativ umfasst die Scannereinheit ein Funkmodul, wobei die Scannereinheit dann dazu ausgebildet ist, um RFID-Tags zu lesen.

Erfindungsgemäß ist die Berührungserkennungseinheit dazu ausgebildet, um elektrostatische Entladungen am Gehäuse aufgrund von Berührungen zu erkennen. Diese elektrostatischen Entladungen am Gehäuse korrespondieren zu einer Berührung. Die Berührungserkennungseinheit ist weiter dazu ausgebildet, um die Information der Berührung an die Datenverarbeitungseinheit zu übertragen. Dadurch, dass die Berührungserkennungseinheit elektrostatische Entladungen erfassen kann, können auch ganz sanfte Berührungen sicher erkannt werden. Im Gegensatz zu einem Beschleunigungssensor werden so minimalste Berührungen erfasst.

In einer vorteilhaften Ausführungsform ist die Datenverarbeitungseinheit dazu ausgebildet, um aufgrund der Intensität der elektrostatischen Entladung Rückschlüsse auf eine Art der Berührung ziehen zu können, wobei die Datenverarbeitungseinheit weiter dazu ausgebildet ist, um die Art der Berührung in einer Speichereinheit zu protokollieren und/oder über die Kommunikationseinheit an eine übergeordnete Datenverarbeitungsvorrichtung zu übertragen. So kann in Abhängigkeit der Intensität beispielsweise festgestellt werden, ob die Berührung mit einem Handschuh oder ohne einen Handschuh erfolgt.

Bevorzugt erfolgt die Erfassung der elektrostatischen Entladung daher analog. Weiter bevorzugt ist ein Analog-/Digital-Wandler vorgesehen, der Bestandteil der Berührungserkennungseinheit ist. Für bestimmte Höhen der elektrostatischen Entladung können in einer Speichereinheit verschiedenen Arten der Berührung hinterlegt sein, die beispielsweise durch Versuche ermittelt worden sind. Der Analog-/Digital-Wandler kann natürlich auch in der Datenverarbeitungseinheit integriert sein. Liegt der Ausgabewert des Analog-/Digital-Wandlers oberhalb eines Schwellwerts, so kann eine Berührung angenommen werden. Die Information, dass die Lesevorrichtung berührt wurde, kann dann an die übergeordnete Datenverarbeitungsvorrichtung übertragen werden und/oder in der Speichereinheit protokolliert werden. Es kann auch die Höhe der elektrostatischen Entladung übermittelt bzw. protokolliert werden.

Erfindungsgemäß ist das Gehäuse elektrisch leitfähig und besteht aus Metall oder umfasst Metall bzw. besteht aus einer Metalllegierung oder umfasst eine Metalllegierung. Dadurch kann eine elektrostatische Entladung besonders effizient ermittelt werden.

In einer vorteilhaften Ausführungsform umfasst die Berührungserkennungseinheit zumindest einen Verstärker, der dazu ausgebildet ist, um die elektrostatischen Entladungen zu verstärken. Bei der elektrostatischen Entladung fließen zum Teil nur sehr kleine Ströme, die durch den zumindest einen Verstärker entsprechend vorverarbeitet werden, damit eine spätere Erkennung möglich ist. Der Verstärker ist bevorzugt mit der Datenverarbeitungseinheit, insbesondere mit einem Eingang der Datenverarbeitungseinheit (z.B. GPIO (general-purpose input/output Pin)) oder einem Analog-/Digital-Wandler elektrisch verbunden. Die Datenverarbeitungseinheit ist vorzugsweise ein Mikrocontroller. Auch ein FPGA (engl. Field Programmable Gate Array) könnte eingesetzt werden.

In einer vorteilhaften Ausführungsform umfasst das Gehäuse verschiedene Gehäuseteile, wobei die verschiedenen Gehäuseteile gegeneinander elektrisch isoliert sind. Die Berührungserkennungseinheit ist dazu ausgebildet, um zu detektieren, welcher Gehäuseteil gerade berührt wurde. Bei den verschiedenen Gehäuseteilen handelt es sich insbesondere um die entsprechenden Seiten des Gehäuses. So kann die Berührungserkennungseinheit dazu ausgebildet sein, um elektrostatische Entladungen von jedem Gehäuseteil individuell zu erfassen. Diese Information, also beispielsweise wie oft, wann, wie stark und/oder wie lange der jeweilige Gehäuseteil berührt wurde, kann dann an die Datenverarbeitungseinheit übertragen werden. Die Datenverarbeitungseinheit ist wiederum dazu ausgebildet, um diese Information mittels der Kommunikationseinheit an eine übergeordnete Datenverarbeitungsvorrichtung zu übertragen oder in einer Speichereinheit zu protokollieren.

In einer vorteilhaften Ausführungsform ist die Datenverarbeitungseinheit dazu ausgebildet, um einen Zeitpunkt der Berührung in einer Speichereinheit zu protokollieren und/oder über die Kommunikationseinheit an eine übergeordnete Datenverarbeitungsvorrichtung zu übertragen. Dieser Zeitpunkt kann die Uhrzeit (vorzugsweise mindestens minutengenau) und/oder das Datum umfassen.

In einer vorteilhaften Ausführungsform ist die Datenverarbeitungseinheit dazu ausgebildet, um eine Zeitdauer der Berührung in einer Speichereinheit zu protokollieren und/oder über die Kommunikationseinheit an eine übergeordnete Datenverarbeitungsvorrichtung zu übertragen. Die Zeitdauer kann beispielsweise angeben, wie lange die Berührung vorliegt (vorzugsweise kann die Dauer der Berührung zumindest in zehntel Sekunden genau angegeben werden).

Grundsätzlich ist es möglich, dass die Datenverarbeitungseinheit einen Zähler umfasst, der jede Berührung mitzählt. Vorzugsweise wird der Zähler bei jeder Art von Berührung inkrementiert.

Weiterhin wäre es denkbar, dass die Datenverarbeitungseinheit dazu ausgebildet ist, um bei einem vorbestimmten Zählerstand eine Information an eine übergeordnete Datenverarbeitungsvorrichtung zu übertragen, die angibt, dass eine bestimmte Anzahl von Berührungen stattgefunden hat, sodass durch Betriebspersonal eine Überprüfung der Lesevorrichtung vorgenommen wird.

In einer vorteilhaften Ausführungsform ist die Datenverarbeitungseinheit dazu ausgebildet, um Berührungsmuster zu erkennen. Die Berührungsmuster umfassen vorzugsweise eine Vielzahl von Berührungen in einem bestimmten Zeitraum und/oder mit einer bestimmten Berührungsdauer. Ein Berührungsmuster kann beispielsweise aus kurzen Berührungen (z.B. weniger als 1 Sekunde) und langen Berührungen (z.B. länger als 1 Sekunde und kürzer als 5 Sekunden) bestehen. Ein Berührungsmuster kann beispielsweise aus drei kurzen Berührungen und einer langen Berührung bestehen. Die Berührungen finden dabei zeitlich voneinander beabstandet statt.

In einer vorteilhaften Ausführungsform ist die Datenverarbeitungseinheit dazu ausgebildet, um je nach Berührungsmuster in einen bestimmten Betriebsmodus zu wechseln. Je nach Betriebsmodus kann beispielsweise auch eine bestimmte Aktion in der Lesevorrichtung angestoßen, also ausgeführt werden. Ein Betriebsmodus ist beispielsweise ein "Quickstart" für z.B. 30 Sekunden, um eine Testlesung einer Information (von einem 1D-Code, 2D-Code oder RFID-Tag) durchzuführen, um festzustellen, ob diese Information richtig oder falsch erfasst wurde. Die Ausgabe, also ob die Testlesung fehlerfrei oder nicht fehlerfrei erfolgt ist, kann über die Kommunikationseinheit an eine übergeordnete Datenverarbeitungsvorrichtung erfolgen oder über ein visuelles Mittel (zum Beispiel LED) oder über ein akustisches Mittel ausgegeben werden. Ein anderer Betriebsmodus ist beispielsweise "Profile-Programmierung", in welchem die Lesevorrichtung mit einer einzulesenden Information umprogrammiert bzw. umparametriert werden kann. Diese Information kann über einen oder mehrere 1D-Code(s), 2D-Code(s) oder RFID-Tag(s) eingelesen werden. Grundsätzlich ist es denkbar, dass alle theoretisch vorhandenen Funktionen, die die Lesevorrichtung unterstützt, in dem jeweiligen Betriebsmodus ausgeführt werden können.

In einer vorteilhaften Ausführungsform umfasst die Lesevorrichtung eine Leiterplatte. Die Leiterplatte umfasst zumindest eine Leiterbahn, an die die Berührungserkennungseinheit angeschlossen ist. In einer ersten Ausführungsform umfasst das Gehäuse an seiner Innenseite einen Kontaktierungsvorsprung, welcher im geschlossenen Zustand des Gehäuses die Leiterbahn elektrisch kontaktiert. Dadurch kann eine elektrostatische Entladung direkt auf die Leiterbahn übertragen werden. Diese elektrostatische Entladung kann beispielsweise zu einem Verstärker übermittelt werden, um verstärkt der Datenverarbeitungseinheit zugeführt zu werden. Die elektrostatische Entladung kann auch direkt der Datenverarbeitungseinheit zugeführt werden, wobei die Berührungserkennungseinheit in diesem Fall Teil der Datenverarbeitungseinheit (zum Beispiel in Form eines internen Analog-/Digital-Wandlers) ist. In einer zweiten Ausführungsform weist das Gehäuse eine Schraubverbindung auf, wobei die Schraubverbindung im geschlossenen Zustand des Gehäuses die Leiterbahn elektrisch kontaktiert. Die elektrostatische Entladung kann in diesem Fall über die Schraubverbindung auf die Leiterbahn übertragen werden. In einer dritten Ausführungsform ist eine Kabelverbindung vorgesehen, die die Innenseite des Gehäuses mit der Leiterbahn elektrisch verbindet. Selbstverständlich können noch weitere Möglichkeiten vorgesehen werden, wie eine elektrische Verbindung zwischen dem Gehäuse und der Berührungserkennungseinheit erfolgen kann.

In einer vorteilhaften Ausführungsform ist die Datenverarbeitungseinheit dazu ausgebildet, um eine detektierte Berührung des Gehäuses mit anderen Ereignissen zu korrelieren. Bei diesen anderen Ereignissen kann es sich beispielsweise um eine Unterbrechung der Kommunikation zwischen der Kommunikationseinheit und einer übergeordneten Datenverarbeitungsvorrichtung handeln. Ergänzend oder alternativ kann es sich bei dem Ereignis um eine Verschlechterung der Leserate und/oder um eine Unterbrechung des Lesens der Information auf den Objekten handeln. Durch eine solche Korrelation kann die Fehleranalyse beschleunigt werden. Insbesondere werden hierzu auch die historischen Daten der Berührungen (zum Beispiel inklusive des Datums, der Uhrzeit und/oder der Berührungsdauer) herangezogen. Wird beispielsweise die Frontscheibe bei Einsatz eines optischen Scannermoduls verschmutzt, so ist ein Auslesen der Information schlechter oder nicht mehr möglich. Wird die Position der Lesevorrichtung verändert, zum Beispiel durch Verkippen oder Verdrehen der Lesevorrichtung, so kann die Qualität des Auslesens ebenfalls stark beeinträchtigt werden. Auch das Unterbrechen der Verbindungsleitungen (bei einer kabelgebundenen Verbindung) zwischen der Kommunikationseinheit und einer übergeordneten Datenverarbeitungsvorrichtung kann dazu führen, dass Leseergebnisse verloren gehen. Dies gilt insbesondere bei Vorliegen eines Wackelkontakts. Auch die Betätigung eines Knopfes oder Tasters an der Lesevorrichtung kann die Auslesequalität beeinträchtigen. Selbiges gilt auch für das Entfernen von Speicherkarten. Hat sich die Qualität des Auslesens daher verschlechtert, und ist diese Verschlechterung nach Erkennung eine Berührung aufgetreten, so kann die Fehlerbehebung deutlich beschleunigt werden.

In einer vorteilhaften Ausführungsform ist die Lesevorrichtung (im Betrieb) stationär, also ortsfest angeordnet. In diesem Fall werden die Objekte an der Lesevorrichtung vorbei bewegt.

In einer vorteilhaften Ausführungsform ist die Lesevorrichtung dazu ausgebildet, um die berührungslos ausgelesen Informationen über die Kommunikationseinheit an eine übergeordnete Datenverarbeitungsvorrichtung zu übertragen.

In einer vorteilhaften Ausführungsform umfasst die Lesevorrichtung eine optische Anzeige, insbesondere in Form einer LED. Die Datenverarbeitungseinheit ist dazu ausgebildet, um bei einer erkannten Berührung die optische Anzeige entsprechend anzusteuern, sodass diese Berührung visualisiert wird. Insbesondere wird die LED aktiviert. Dadurch kann das Betriebspersonal auf die Berührung der Lesevorrichtung aufmerksam gemacht werden, wobei das Betriebspersonal in diesem Fall die Funktionsweise der Lesevorrichtung überprüfen kann. Grundsätzlich wäre auch ein akustisches Mittel zur Ausgabe der Information, dass die Lesevorrichtung berührt wurde, denkbar.

In einer vorteilhaften Ausführungsform sind zumindest die Datenverarbeitungseinheit und die Berührungserkennungseinheit innerhalb des Gehäuses der Lesevorrichtung angeordnet. Grundsätzlich könnte auch die Kommunikationseinheit und/oder die Scannereinheit (zumindest teilweise) innerhalb des Gehäuses der Lesevorrichtung angeordnet sein.

Das erfindungsgemäße Verfahren dient zur Absicherung der Lesevorrichtung, die zum berührungslosen Auslesen von Informationen auf Objekten verwendet wird. In einem ersten Verfahrensschritt wird das Gehäuse der Lesevorrichtung dahingehend überwacht, ob eine Berührung des Gehäuses stattfindet. In einem zweiten Verfahrensschritt wird die Berührung protokolliert. Ergänzend oder alternativ wird die Tatsache, dass eine Berührung stattgefunden hat, über die Kommunikationseinheit an eine übergeordnete Datenverarbeitungsvorrichtung übertragen. Weiterhin werden elektrostatische Entladungen am Gehäuse aufgrund von Berührungen erkannt. Dabei ist das Gehäuse elektrisch leitfähig und besteht aus Metall oder einer Metalllegierung oder umfasst eine solche.

Nachfolgend wird die Erfindung rein beispielhaft unter Bezugnahme auf die Zeichnungen beschrieben. Es zeigen:
- Figur 1:: ein Ausführungsbeispiel der erfindungsgemäßen Lesevorrichtung, die eine Information von einem Objekt auf einem Förderband ausliest;
- Figuren 2A, 2B:: einen beispielhaften Längsschnitt durch ein Gehäuse der Lesevorrichtung, aus dem hervorgeht wie elektrostatische Entladungen am Gehäuse erfasst werden können;
- Figur 3:: Daten, die im Zusammenhang mit einer Berührung des Gehäuses protokolliert werden können; und
- Figur 4:: ein Flussdiagramm, welches die Funktionsweise der Lesevorrichtung beschreibt.

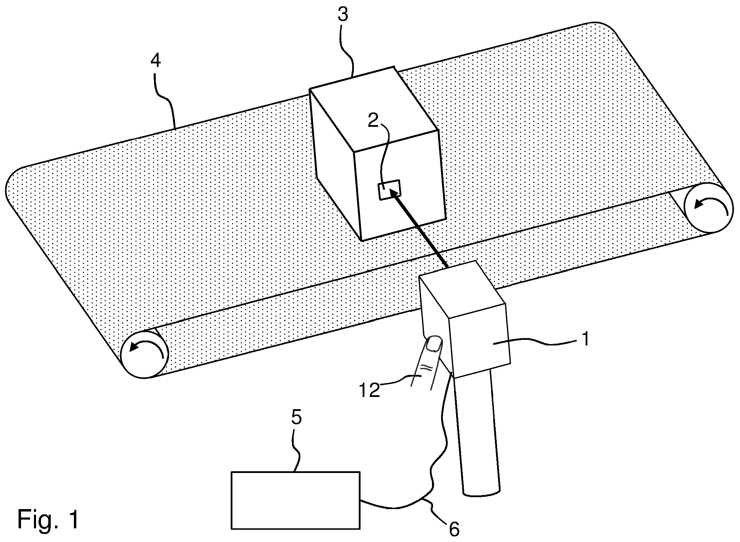

Figur 1 zeigt ein Ausführungsbeispiel einer erfindungsgemäßen Lesevorrichtung 1, die dazu ausgebildet ist, um eine Information 2 von einem Objekt 3 auf einem Förderband 4 auszulesen. Die Information 2 kann ein 1D-Code (Barcode), 2D-Code (QR-Code) oder ein RFID-Tag sein. Das Auslesen erfolgt berührungsfrei. Bevorzugt wird das Objekt 3, beispielsweise ein Paket, an der Lesevorrichtung 1 vorbei bewegt. Die ausgelesene Information 2 kann dann dazu verwendet werden, um das Objekt 3 zu einer bestimmten Station zu leiten (z.B. zum richtigen Transportfahrzeug).

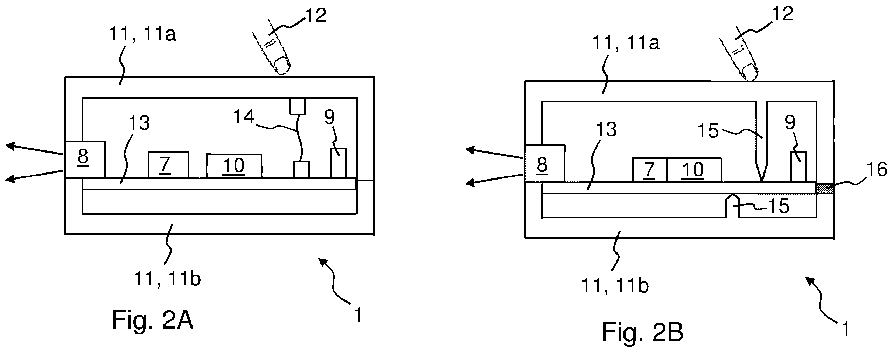

Grundsätzlich wäre es denkbar, dass es eine Vielzahl von Lesevorrichtungen 1 gibt, um verschiedene Seiten des Objekts 3 abzuscannen. Die erfasste Information 2 kann dann an eine übergeordnete Datenverarbeitungsvorrichtung 5 übertragen werden. Dies erfolgt bevorzugt über eine Kabelverbindung 6. Bevorzugt wird hierzu eine TCP/IP-Verbindung, Ethernet-Verbindung, Profibus, Profinet und/oder CAN-Bus verwendet. Die Lesevorrichtung 1 umfasst eine Datenverarbeitungseinheit 7, eine Scannereinheit 8, eine Kommunikationseinheit 9, eine Berührungserkennungseinheit 10 und ein Gehäuse 11 (sie Figuren 2A, 2B).

Die Scannereinheit 8 kann ein optisches Scannermodul (zum Beispiel Lasereinheit, Kameraeinheit) umfassen und ist dazu ausgebildet, um optische Codes, insbesondere 1D-Codes und/oder 2 zu lesen. Ergänzend oder alternativ könnte die Scannereinheit 8 auch ein Funkmodul umfassen, wodurch die Scannereinheit 8 dazu ausgebildet ist, um RFID-Tags zu lesen.

Die Berührungserkennungseinheit 10 ist dazu ausgebildet, um elektrostatische Entladungen am Gehäuse 11 aufgrund von Berührungen zu erkennen. Eine solche Berührung wird in den Figuren 1, 2A, 2B durch einen Finger 12 symbolisiert.

Nach einer erkannten Berührung ist die Datenverarbeitungseinheit 7 vorzugsweise dazu ausgebildet, um diese Berührung zu protokollieren und/oder an die übergeordnete Datenverarbeitungsvorrichtung 5 zu übertragen. Hierfür wird bevorzugt dieselbe Kabelverbindung 6 verwendet, über welche auch die eingelesene Information 2 übertragen wird.

In Figur 2A ist ein beispielhafter Längsschnitt durch die Lesevorrichtung 1 dargestellt. Das Gehäuse 11 umfasst in diesem Fall zwei Gehäuseteile 11a, 11b, die vorzugsweise halbschalenförmig aufgebaut sind. Beide Gehäuseteile 11a, 11b sind vorzugsweise miteinander verschraubt. Sie könnten auch miteinander verrastet sein.

Die Lesevorrichtung 1 umfasst vorzugsweise eine Leiterplatte 13, die weiter vorzugsweise ausschließlich innerhalb des Gehäuses 11 angeordnet ist. Auf der Leiterplatte 13 sind vorzugsweise die Datenverarbeitungseinheit 7, die Scannereinheit 8, die Kommunikationseinheit 9 und die Berührungserkennungseinheit 10 angeordnet. Vorzugsweise sind die Datenverarbeitungseinheit 7, die Scannereinheit 8, die Kommunikationseinheit 9 und die Berührungserkennungseinheit 10 auf derselben Seite der Leiterplatte 13 angeordnet. Die Scannereinheit 8 ist außerdem in einer Öffnung im Gehäuse 11 angeordnet, sodass Objekte 3, die an der Lesevorrichtung 1 vorbeigeführt werden, in ihr Sichtfeld gelangen. Das Sichtfeld wird durch zwei Pfeile symbolisiert.

Das Gehäuse 11 ist mit einer Leiterbahn der Leiterplatte 13 über eine Kabelverbindung 14 verbunden. Über diese Kabelverbindung 14 werden elektrostatische Entladungen übertragen. Die Kabelverbindung 14 kann an eine Innenseite des Gehäuses 11 mittels einer Lötverbindung und/oder einem Steckkontakt angeschlossen werden.

Das Gehäuse 11 ist elektrisch leitfähig. Bevorzugt besteht das Gehäuse 11 aus Metall oder umfasst Metall. Das Gehäuse 11 könnte auch aus einer Metalllegierung bestehen oder eine solche umfassen.

In Figur 2B umfasst das Gehäuse 11 einen Kontaktierungsvorsprung 15 der einteilig an dem Gehäuse 11 bzw. einteilig an dem jeweiligen Gehäuseteil 11a, 11b ausgebildet sein kann. Der Kontaktierungsvorsprung 15 kann auch an das Gehäuse 11 bzw. an den jeweiligen Gehäuseteil 11a, 11b gelötet sein. Auch der Einsatz einer Klebeverbindung, sofern diese elektrisch leitfähig ist, wäre denkbar. Der Kontaktierungsvorsprung 15 könnte ich Richtung der Leiterplatte 13 spitz zulaufen. Der Kontaktierungsvorsprung 15 kontaktiert die Leiterbahn der Leiterplatte 13 im geschlossenen Zustand des Gehäuses 11. Auf diese Art und Weise kann eine elektrostatische Entladung sehr einfach vom Gehäuse 11 auf die Leiterbahn der Leiterplatte 13 übertragen werden, um im Anschluss von der Berührungserkennungseinheit 10 erfasst und an die Datenverarbeitungseinheit 7 übertragen zu werden.

In Figur 2B sind zwei Kontaktierungsvorsprünge 15 dargestellt. Ein erster Kontaktierungsvorsprung 15 ist an dem ersten Gehäuseteil 11a angebracht und ein zweiter Kontaktierungsvorsprung 15 ist an dem zweiten Gehäuseteil 11b angebracht. Beide Kontaktierungsvorsprünge 15 kontaktieren unterschiedliche Leiterbahnen auf der Leiterplatte 13. Der erste Gehäuseteil 11a und der zweite Gehäuseteil 11b sind galvanisch voneinander getrennt. Dies kann beispielsweise durch ein dielektrisches Element 16 erfolgen, welches zwischen beiden Gehäuseteilen 11a, 11b eingelegt, eingepresst und/oder eingeklebt ist. Bei dem dielektrischen Element 16 kann es sich beispielsweise um einen (umlaufenden) Dichtgummi handeln. Dadurch ist es der Berührungserkennungseinheit 10 möglich zu erkennen, welcher Gehäuseteil 11a, 11b von einem Benutzer berührt wurde.

Die Berührungserkennungseinheit 10 umfasst vorzugsweise einen Verstärker, der dazu ausgebildet ist, um die elektrostatische Entladung zu verstärken.

In Figur 2B ist außerdem dargestellt, dass die Datenverarbeitungseinheit 7 und die Berührungserkennungseinheit 10 in einem gemeinsamen Gehäuse integriert sind. Dies kann durch einen Mikrocontroller, der beispielsweise über einen Analog-/Digital-Wandler verfügt, erfolgen.

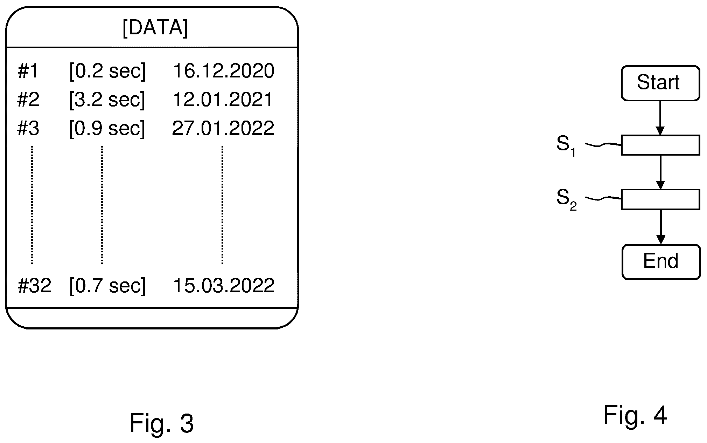

Figur 3 zeigt eine Übersicht über Daten, die im Zusammenhang mit einer Berührung des Gehäuses 11 protokolliert werden können. Grundsätzlich wird vorzugsweise jede Berührung protokolliert. Ein Zähler wird hierbei weiter vorzugsweise inkrementiert. Dies wird über die Ziffernfolgen #1, #2, #3, ..., #32 ausgedrückt.

Vorzugsweise wird auch die Zeitdauer der Berührung gespeichert. In Figur 3 beträgt die Zeitdauer der Berührung zwischen 0,5 s und 3,2 s. Weiter bevorzugt wird auch das Datum der Berührung gespeichert. Ergänzend oder alternativ kann auch die Uhrzeit der Berührung gespeichert werden. Die Uhrzeit wird vorzugsweise minutengenau und weiter vorzugsweise sekundengenau gespeichert.

Die Datenverarbeitungseinheit 7 ist dazu ausgebildet, um diese Daten in einer Speichereinheit zu protokollieren und/oder über die Kommunikationseinheit 9 an die übergeordnete Datenverarbeitungsvorrichtung 5 zu übertragen.

Weiterhin wäre es denkbar, dass die Datenverarbeitungseinheit 7 dazu ausgebildet ist, um aufgrund der Intensität der elektrostatischen Entladung Rückschlüsse auf die genaue Art der Berührung zu erlauben. Diese Art der Berührung kann in einer Speichereinheit protokolliert und/oder über die Kommunikationseinheit 9 an die übergeordnete Datenverarbeitungsvorrichtung 5 übertragen werden.

Figur 4 zeigt ein Flussdiagramm, welches die Funktionsweise der Lesevorrichtung 1 beschreibt. In einem ersten Verfahrensschritt S₁ wird das Gehäuse 11 der Lesevorrichtung 1 durch die Berührungserkennungseinheit 10 auf Berührungen hin überwacht. Insbesondere wird analysiert, ob elektrostatische Entladungen vorliegen oder nicht. In einem zweiten Verfahrensschritt S₂ wird eine entsprechend detektierte Berührung protokolliert. Ergänzend oder alternativ wird eine entsprechend detektierte Berührung über die Kommunikationseinheit 9 der Lesevorrichtung 1 an die übergeordnete Datenverarbeitungsvorrichtung 5 übertragen.

In weiteren nicht dargestellten Verfahrensschritten kann optional die detektierte Berührung mit weiteren Ereignissen, wie einer sich verschlechterten Leserate der Information 2 auf dem Objekt 3 korreliert werden. In einem weiteren nicht dargestellten Verfahrensschritt kann weiterhin optional eine Wartungsinformation für die Lesevorrichtung 1 herausgegeben werden, sodass das Betriebspersonal die Lesevorrichtung 1 überprüft und gegebenenfalls bezüglich ihrer Ausrichtung neu justiert bzw. eine Glasscheibe vor der Scannereinheit 8 reinigt.

Erfindung ist nicht auf die beschriebenen Ausführungsbeispiele beschränkt. Im Rahmen der Erfindung sind alle beschriebenen und/oder gezeichneten Merkmale beliebig miteinander kombinierbar.

### Bezugszeichenliste

| | |
|---|---|
| Lesevorrichtung | 1 |
| Information | 2 |
| Objekt | 3 |
| Förderband | 4 |
| Übergeordnete Datenverarbeitungsvorrichtung | 5 |
| Kabelverbindung | 6 |
| Datenverarbeitungseinheit | 7 |
| Scannereinheit | 8 |
| Kommunikationseinheit | 9 |
| Berührungserkennungseinheit | 10 |
| Gehäuse | 11 |
| Gehäuseteile | 11a, 11b |
| Finger | 12 |
| Leiterplatte | 13 |
| Kabelverbindung | 14 |
| Kontaktierungsvorsprung | 15 |
| Dielektrisches Element | 16 |
| Verfahrensschritte | S₁, S₂ |

## Patentansprüche

1. Lesevorrichtung (1) zum berührungslosen Auslesen von Informationen (2) auf Objekten (3), die an der Lesevorrichtung (1) vorbei führbar sind, wobei die Lesevorrichtung (1) eine Datenverarbeitungseinheit (7), eine Scannereinheit (8), eine Kommunikationseinheit (9), eine Berührungserkennungseinheit (10) und ein Gehäuse (11) aufweist, wobei die Berührungserkennungseinheit (10) dazu ausgebildet ist, um Berührungen des Gehäuses (11) der Lesevorrichtung (1) zu erkennen, **dadurch gekennzeichnet, dass** die Berührungserkennungseinheit (10) dazu ausgebildet ist, elektrostatische Entladungen am Gehäuse (11) aufgrund von Berührungen zu erkennen und wobei das Gehäuse (11) elektrisch leitfähig ist und aus Metall oder einer Metalllegierung besteht oder eine solche umfasst.

2. Lesevorrichtung (1) nach Anspruch 1,
wobei die Scannereinheit (8):
a) ein optisches Scannermodul umfasst, wobei die Scannereinheit (8) dazu ausgebildet ist, um Informationen (2) in Form von optischen Codes, insbesondere 1D- und/oder 2D-Codes, zu lesen; und/oder
b) ein Funkmodul umfasst, wobei die Scannereinheit (8) dazu ausgebildet ist, um Informationen (2) in Form von RFID-Tags zu lesen.

3. Lesevorrichtung (1) nach Anspruch 1 oder 2 ,
wobei die Datenverarbeitungseinheit (7) dazu ausgebildet ist, um aufgrund der Intensität der elektrostatischen Entladung Rückschlüsse auf eine Art der Berührung ziehen zu können und wobei die Datenverarbeitungseinheit (7) weiter dazu ausgebildet ist, um die Art der Berührung:
a) in einer Speichereinheit zu protokollieren; und/oder
b) über die Kommunikationseinheit (9) an eine übergeordnete Datenverarbeitungsvorrichtung (5) zu übertragen.

4. Lesevorrichtung (1) nach einem der vorstehenden Ansprüche,
wobei die Berührungserkennungseinheit (10) zumindest einen Verstärker aufweist, der dazu ausgebildet ist, um die elektrostatischen Entladungen zu verstärken.

5. Lesevorrichtung (1) nach einem der vorstehenden Ansprüche,
wobei das Gehäuse (11) verschiedene Gehäuseteile (11a, 11b) umfasst, die gegeneinander elektrisch isoliert sind, wobei die Berührungserkennungseinheit (10) dazu ausgebildet ist, um zu detektieren, welcher Gehäuseteil (11a, 11b) berührt wird.

6. Lesevorrichtung (1) nach einem der vorstehenden Ansprüche,
wobei die Datenverarbeitungseinheit (7) dazu ausgebildet ist, um einen Zeitpunkt der Berührung:
a) in einer Speichereinheit zu protokollieren; und/oder
b) über die Kommunikationseinheit (9) an eine übergeordnete Datenverarbeitungsvorrichtung (5) zu übertragen.

7. Lesevorrichtung (1) nach einem der vorstehenden Ansprüche,
wobei die Datenverarbeitungseinheit (7) dazu ausgebildet ist, um eine Zeitdauer der Berührung:
a) in einer Speichereinheit zu protokollieren; und/oder
b) über die Kommunikationseinheit (9) an eine übergeordnete Datenverarbeitungsvorrichtung (7) zu übertragen.

8. Lesevorrichtung (1) nach einem der vorstehenden Ansprüche,
wobei die Datenverarbeitungseinheit (7) dazu ausgebildet ist, um Berührungsmuster zu erkennen.

9. Lesevorrichtung (1) nach Anspruch 8,
wobei Berührungsmuster eine Vielzahl von Berührungen:
a) in einem bestimmten Zeitraum; und/oder
b) mit einer bestimmten Berührungsdauer umfassen.

10. Lesevorrichtung (1) nach Anspruch 8 oder 9,
wobei die Datenverarbeitungseinheit (7) dazu ausgebildet ist, um je nach Berührungsmuster in einen bestimmten Betriebsmodus zu wechseln.

11. Lesevorrichtung (1) nach einem der vorstehenden Ansprüche,
wobei die Lesevorrichtung (1) eine Leiterplatte (13) umfasst, wobei die Leiterplatte (13) eine Leiterbahn aufweist, an die die Berührungserkennungseinheit (10) angeschlossen ist und wobei:
a) das Gehäuse (11) an seiner Innenseite einen Kontaktierungsvorsprung (15) aufweist, welcher im geschlossenen Zustand des Gehäuses (11) die Leiterbahn elektrisch kontaktiert; oder
b) das Gehäuse (11) eine Schraubverbindung aufweist, wobei die Schraubverbindung im geschlossenen Zustand des Gehäuses (11) die Leiterbahn elektrisch kontaktiert; oder
c) das Gehäuse (11) an seiner Innenseite über eine Kabelverbindung (14) mit der Leiterbahn elektrisch verbunden ist.

12. Lesevorrichtung (1) nach einem der vorstehenden Ansprüche,
wobei die Datenverarbeitungseinheit (7) dazu ausgebildet ist, um eine detektierte Berührung des Gehäuses (11) mit anderen Ereignissen wie:
a) einer Unterbrechung einer Kommunikation zwischen der Kommunikationseinheit (9) und einer übergeordneten Datenverarbeitungsvorrichtung (5); und/oder
b) einer Verschlechterung der Leserate und/oder eine Unterbrechung des Auslesens der Informationen (2) auf Objekten (3), die an der Lesevorrichtung (1) vorbei führbar sind;
zu korrelieren.

13. Verfahren zur Absicherung einer Lesevorrichtung (1) zum berührungslosen Auslesen von Informationen (2) auf Objekten (3), mit den folgenden Verfahrensschritten:
- Überwachen (S₁) eines Gehäuses (11) der Lesevorrichtung (1) dahingehend, ob eine Berührung des Gehäuses (11) stattfindet;
- Protokollieren (S₂), dass eine Berührung stattgefunden hat; und/oder Übertragen (S₂), dass eine Berührung stattgefunden hat über eine Kommunikationseinheit (9) der Lesevorrichtung (1) an eine übergeordnete Datenverarbeitungsvorrichtung (5),
wobei elektrostatische Entladungen am Gehäuse (11) aufgrund von Berührungen erkannt werden und wobei das Gehäuse (11) elektrisch leitfähig ist und aus Metall oder einer Metalllegierung besteht oder eine solche umfasst.

## Claims

1. A reading apparatus (1) for a contactless readout of information (2) on objects (3) which can be guided past the reading apparatus (1), wherein the reading apparatus (1) has a data processing unit (7), a scanner unit (8), a communication unit (9), a contact recognition unit (10), and a housing (11), wherein the contact recognition unit (10) is configured to recognize contacts with the housing (11) of the reading apparatus (1),
**characterized in that**
the contact recognition unit (10) is configured to recognize electrostatic discharges at the housing (11) based on contacts and wherein the housing (11) is electrically conductive and is composed of or consists of metal or a metal alloy.

2. A reading apparatus (1) according to claim 1,
wherein the scanner unit (8):
a) comprises an optical scanner module, wherein the scanner unit (8) is configured to read information (2) in the form of optical codes, in particular 1D codes and/or 2D codes, and/or
b) comprises a radio module, wherein the scanner unit (8) is configured to read information (2) in the form of RFID tags.

3. A reading apparatus (1) according to claim 1 or 2,
wherein the data processing unit (7) is configured to be able to draw conclusions about a type of the contact based on the intensity of the electrostatic discharge, and wherein the data processing unit (7) is further configured:
a) to record the type of the contact in a memory unit; and/or
b) to transmit the type of the contact to a higher-ranking data processing apparatus (5) via the communication unit (9).

4. A reading apparatus (1) according to any one of the preceding claims, wherein the contact recognition unit (10) comprises at least one amplifier which is configured to amplify the electrostatic discharges.

5. A reading apparatus (1) according to any one of the preceding claims, wherein the housing (11) comprises different housing parts (11a, 11b) which are electrically insulated from one another, wherein the contact recognition unit (10) is configured to detect which housing part (11a, 11b) is contacted.

6. A reading apparatus (1) according to any one of the preceding claims, wherein the data processing unit (7) is configured:
a) to record a point in time of the contact in a memory unit; and/or
b) to transmit a point in time of the contact to a higher-ranking data processing apparatus (5) via the communication unit (9).

7. A reading apparatus (1) according to any one of the preceding claims, wherein the data processing unit (7) is configured:
a) to record a time duration of the contact in a memory unit; and/or
b) to transmit a time duration of the contact to a higher-ranking data processing apparatus (7) via the communication unit (9).

8. A reading apparatus (1) according to any one of the preceding claims, wherein the data processing unit (7) is configured to recognize a contact pattern.

9. A reading apparatus (1) according to claim 8,
wherein contact patterns comprise a plurality of contacts:
a) in a certain time period; and/or
b) with a certain contact duration.

10. A reading apparatus (1) according to claim 8 or 9,
wherein the data processing unit (7) is configured to switch to a specific operating mode depending on the contact pattern.

11. A reading apparatus (1) according to any one of the preceding claims,
wherein the reading apparatus (1) comprises a circuit board (13), wherein the circuit board (13) has a conductor path to which the contact recognition unit (10) is connected, and wherein:
a) the housing (11) has, at its inner side, a contacting projection (15) which electrically contacts the conductor path in the closed state of the housing (11); or
b) the housing (11) has a screw connection, wherein the screw connection electrically contacts the conductor path in the closed state of the housing (11); or
c) the housing (11) is electrically connected at its inner side to the conductor path via a cable connection (14).

12. A reading apparatus (1) according to any one of the preceding claims,
wherein the data processing unit (7) is configured to correlate a detected contact with the housing (11) with other events such as:
a) an interruption of a communication between the communication unit (9) and a higher-ranking data processing apparatus (5); and/or
b) a deterioration of the reading rate and/or an interruption of the readout of the information (2) on objects (3) which can be guided past the reading apparatus (1).

13. A method for safeguarding a reading apparatus (1) for a contactless readout of information (2) on objects (3), comprising the following method steps:
- monitoring (S₁) a housing (11) of the reading apparatus (1) as to whether a contact with the housing (11) is taking place;
- recording (S₂) that a contact has taken place; and/or communicating (S₂) that a contact has taken place to a higher-ranking data processing apparatus (5) via a communication unit (9) of the reading apparatus (1),
wherein electrostatic discharges at the housing (11) are recognized based on contacts and wherein the housing (11) is electrically conductive and is composed of or consists of metal or a metal alloy.

## Revendications

1. Dispositif de lecture (1) pour la lecture sans contact physique d'informations (2) sur des objets (3) qui peuvent passer devant le dispositif de lecture (1), le dispositif de lecture (1) comportant une unité de traitement de données (7), une unité de balayage (8), une unité de communication (9), une unité de détection de contact physique (10) et un boîtier (11), l'unité de détection de contact physique (10) étant conçue pour détecter des contacts physiques avec le boîtier (11) du dispositif de lecture (1),
**caractérisé en ce que**
l'unité de détection de contact physique (10) est conçue pour détecter des décharges électrostatiques sur le boîtier (11) dues à des contacts physiques, et le boîtier (11) est électriquement conducteur et est constitué ou contient un métal ou un alliage métallique.

2. Dispositif de lecture (1) selon la revendication 1,
dans lequel l'unité de balayage (8) comprend
a) un module de balayage optique, l'unité de balayage (8) étant conçue pour lire des informations (2) sous forme de codes optiques, en particulier sous forme de codes 1D et/ou 2D ; et/ou
b) un module radio, l'unité de balayage (8) étant conçue pour lire des informations (2) sous forme d'étiquettes RFID.

3. Dispositif de lecture (1) selon la revendication 1 ou 2,
dans lequel l'unité de traitement de données (7) est conçue pour pouvoir tirer des conclusions sur un type de contact physique en raison de l'intensité de la décharge électrostatique, et
l'unité de traitement de données (7) est en outre conçue pour
a) enregistrer le type de contact physique dans une unité de mémoire ; et/ou
b) le transmettre à un dispositif de traitement de données (5) de niveau supérieur par l'intermédiaire de l'unité de communication (9).

4. Dispositif de lecture (1) selon l'une des revendications précédentes, dans lequel l'unité de détection de contact physique (10) comprend au moins un amplificateur conçu pour amplifier les décharges électrostatiques.

5. Dispositif de lecture (1) selon l'une des revendications précédentes,
dans lequel le boîtier (11) comprend différentes parties de boîtier (11a, 11b) isolées électriquement les unes des autres, l'unité de détection de contact physique (10) étant conçue pour détecter quelle partie de boîtier (11a, 11b) est touchée.

6. Dispositif de lecture (1) selon l'une des revendications précédentes,
dans lequel l'unité de traitement de données (7) est conçue pour
a) enregistrer un instant de contact physique dans une unité de mémoire ; et/ou
b) le transmettre à un dispositif de traitement de données (5) de niveau supérieur par l'intermédiaire de l'unité de communication (9).

7. Dispositif de lecture (1) selon l'une des revendications précédentes,
dans lequel l'unité de traitement de données (7) est conçue pour
a) enregistrer une durée du contact physique dans une unité de mémoire ; et/ou
b) la transmettre à un dispositif de traitement de données (7) de niveau supérieur par l'intermédiaire de l'unité de communication (9).

8. Dispositif de lecture (1) selon l'une des revendications précédentes,
dans lequel l'unité de traitement de données (7) est conçue pour détecter des schémas de contact physique.

9. Dispositif de lecture (1) selon la revendication 8,
dans lequel les schémas de contact physique comprennent une pluralité de contacts physiques
a) dans un laps de temps déterminé ; et/ou
b) avec une durée de contact physique déterminée.

10. Dispositif de lecture (1) selon la revendication 8 ou 9,
dans lequel l'unité de traitement de données (7) est conçue pour passer dans un mode de fonctionnement déterminé en fonction du schéma de contact physique.

11. Dispositif de lecture (1) selon l'une des revendications précédentes,
dans lequel le dispositif de lecture (1) comprend une carte de circuit imprimé (13), la carte de circuit imprimé (13) présentant une piste conductrice à laquelle l'unité de détection de contact physique (10) est connectée, et
a) le boîtier (11) présente sur sa face intérieure une saillie de mise en contact (15) qui, lorsque le boîtier (11) est fermé, établit un contact électrique avec la piste conductrice ; ou
b) le boîtier (11) présente un raccord vissé, le raccord vissé établissant un contact électrique avec la piste conductrice lorsque le boîtier (11) est fermé ; ou
c) le boîtier (11) est connecté électriquement à la piste conductrice sur sa face intérieure par l'intermédiaire d'une connexion par câble (14).

12. Dispositif de lecture (1) selon l'une des revendications précédentes,
dans lequel l'unité de traitement de données (7) est conçue pour combiner un contact physique détecté avec le boîtier (11) avec d'autres événements tels que :
a) une interruption d'une communication entre l'unité de communication (9) et un dispositif de traitement de données (5) de niveau supérieur ; et/ou
b) une détérioration du taux de lecture et/ou une interruption de la lecture des informations (2) sur des objets (3) pouvant passer devant le dispositif de lecture (1).

13. Procédé de sécurisation d'un dispositif de lecture (1) pour la lecture sans contact physique d'informations (2) sur des objets (3), comprenant les étapes de procédé suivantes consistant à :
- surveiller (S₁) un boîtier (11) du dispositif de lecture (1) pour savoir si un contact physique avec le boîtier (11) a lieu ;
- enregistrer (S₂) qu'un contact physique a eu lieu ; et/ou transmettre (S₂) qu'un contact physique a eu lieu par l'intermédiaire d'une unité de communication (9) du dispositif de lecture (1) à un dispositif de traitement de données (5) de niveau supérieur,
dans lequel
des décharges électrostatiques sur le boîtier (11) dues à des contacts physiques sont détectées, et le boîtier (11) est électriquement conducteur et est constitué ou contient un métal ou un alliage métallique.
